**Europäisches Patentamt**

(19) **European Patent Office**

**Office européen des brevets**

(11) Veröffentlichungsnummer: **0 155 473**
**A1**

(12) # EUROPÄISCHE PATENTANMELDUNG

(21) Anmeldenummer: **85100975.3**

(22) Anmeldetag: **31.01.85**

(51) Int. Cl.⁴: **H 01 L 21/60**
**H 01 L 21/48, H 01 L 23/48**

(30) Priorität: **23.02.84 DE 3406538**

(43) Veröffentlichungstag der Anmeldung:
**25.09.85 Patentblatt 85/39**

(84) Benannte Vertragsstaaten:
**AT CH DE FR GB IT LI NL**

(71) Anmelder: BROWN, BOVERI & CIE Aktiengesellschaft
Kallstadter Strasse 1
D-6800 Mannheim 31(DE)

(72) Erfinder: Neidig, Arno, Dr. Dipl.-Phys.
Brühler Weg 42
D-6831 Plankstadt(DE)

(74) Vertreter: Kempe, Wolfgang, Dr. et al,
c/o Brown, Boveri & Cie AG Postfach 351
D-6800 Mannheim 1(DE)

(54) **Leistungshalbleitermodul und Verfahren zur Herstellung.**

(57) Zur Herstellung von Leistungshalbleitermodulen werden Lötformen benötigt, die teuer sind und die Durchführung von Änderungen erschweren. Mit der Erfindung wird ein Leistungshalbleitermodul und ein Herstellverfahren vorgeschlagen, die eine Lötform entbehrlich machen. Die Fixierung von Montageteilen (5 bis 9, 18 bis 20, 27, 30) auf einem Substrat (1) vor und während der Lötung erfolgt dabei mit Hilfe von Zapfen (10,26), Krallen (11), Hülsen (12,12.1) oder Winkelstücken (28), die in Justiermarken (4) eingelegt werden. Die Justiermarken (4) sind Vertiefungen in einer Metallisierung (2) auf dem Substrat (1), die gleichzeitig mit Leiterbahnen (3) hergestellt werden.

Fig 2

EP 0 155 473 A1

BROWN, BOVERI & CIE   AKTIENGESELLSCHAFT
Mannheim                                21. Febr. 1984
Mp.-Nr. 520/84                          ZPT/P3-Sf/Bt

## Leistungshalbleitermodul und Verfahren zur Herstellung

Die Erfindung bezieht sich auf ein Leistungshalbleitermodul nach dem Oberbegriff des Anspruchs 1 und ein Verfahren zur Herstellung eines solchen Moduls.

Derartige Leistungshalbleitermodule sind z.B. aus der DE-OS 31 27 457 bekannt. Zur Herstellung solcher Leistungshalbleitermodule ist eine Lötform erforderlich, in die die einzelnen Teile eingesetzt werden und dort auch während des Lötvorgangs in einem Durchlaufofen fixiert werden. Nachteilig sind dabei die hohen Fertigungsaufwendungen, insbesondere die hohen Kosten der Lötform. Schaltungsänderungen erfordern eine teuere Änderung der Lötform bzw. eine neue Lötform.

Der Erfindung liegt die Aufgabe zugrunde, einen Leistungshalbleitermodul und ein Herstellverfahren anzugeben, mit denen die genannten Nachteile vermieden werden.

Diese Aufgabe wird durch ein Leistungshalbleitermodul gemäß Anspruch 1 gelöst. Ein Verfahren zur Herstellung eines solchen Moduls und Ausgestaltungen sind in den Unteransprüchen angegeben.

Die erfindungsgemäße Lösung hat den Vorteil, daß keine Lötformen sondern lediglich kleine einfach herstellbare Löthilfen benötigt werden. Dabei handelt es sich um Justiermarken in Form von Vertiefungen in der Metallisierung auf dem Substrat, in die an Montageteilen angeformte Zapfen oder Krallen oder wiederverwendbare Hilfsteile, wie Hülsen mit Fixierstiften oder Winkelstücke vor dem Löten eingelegt werden. Unter Montageteile sind die Teile, wie z.B. Thyristoren und Anschlußteile, die auf die Metallisierung des Substrats gelötet werden, zu verstehen. An Montageteile angeformte Zapfen oder Krallen sowie die steckbaren bzw. einlegbaren Hilfsteile werden Ausformungen genannt. Die Justiermarken werden gemeinsam mit Leiterbahnen in einem Arbeitsgang hergestellt, so daß kein zusätzlicher Arbeitsgang erforderlich ist und eine hohe Genauigkeit der Lage der Justiermarken erzielt wird. Das mit der Erfindung vorgeschlagene Herstellverfahren ist gut geeignet für eine automatische Bestückung. Bei Schaltungsänderungen wird die Lage der Justiermarken mitgeändert. Die genannten Hilfsteile brauchen dagegen nicht geändert zu werden. Sie sind wie Standardteile einsetzbar.

Weitere Vorteile ergeben sich aus den nachstehenden Ausführungsbeispielen, die anhand der Zeichnung erläutert werden.

Es zeigen:

Fig. 1    Draufsicht auf ein Substrat mit einer strukturierten Metallisierung,

Fig. 2    Draufsicht auf ein bestücktes Substrat,

Fig. 3    rahmenförmiges Metallteil mit Anschlußteilen,

Fig. 4    Schnitt durch ein Substrat, das mit einem rückwärts nicht sperrenden Thyristor bestückt ist,

Fig. 5    Schnitt durch ein Substrat, das mit einem üblichen Thyristor bestückt ist,

Fig. 6    Schnitt durch ein Substrat, das mit einem vorgelöteten Thyristor-Sandwich bestückt ist,

Fig. 7, 8 Beispiel zur Fixierung eines rechteckigen Bauelements auf einem Substrat.

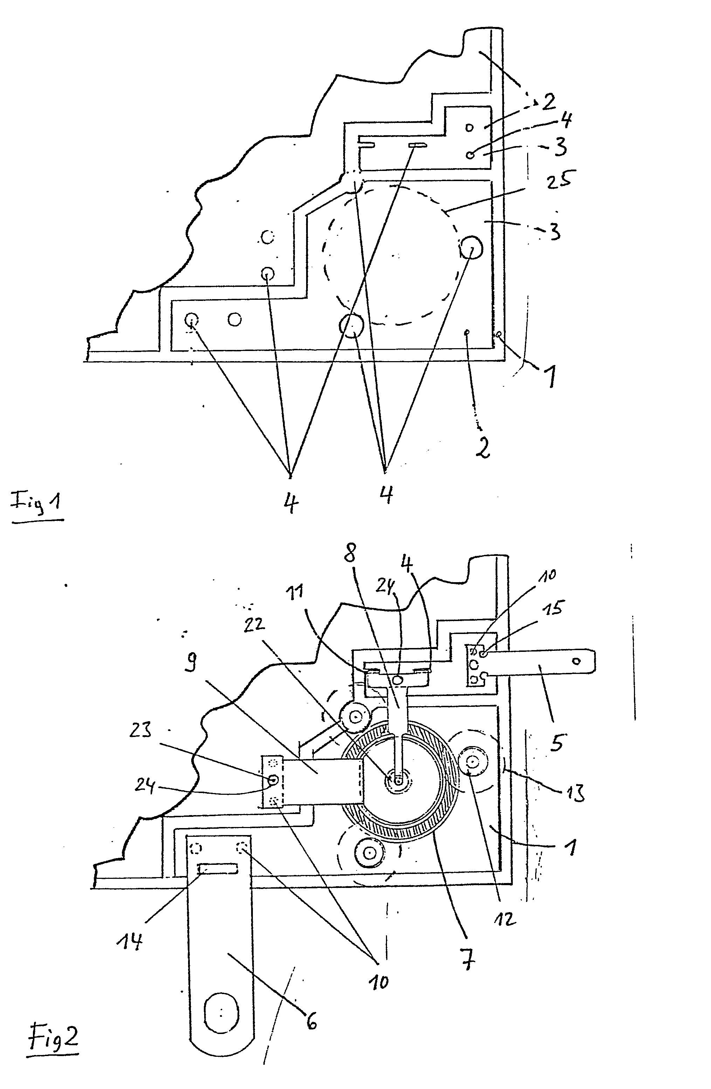

Fig. 1 zeigt eine Draufsicht auf ein Keramiksubstrat 1 mit einer Metallisierung 2. Die Metallisierung 2 wird zweckmäßig als Kupferfolie nach einem Verfahren des direkten Verbindensvon Kupfer mit Keramik aufgebracht. Die Metallisierung 2 ist strukturiert. Diese Strukturierung kann durch Ätzen hergestellt werden. Bei einem solchen Ätzvorgang werden nicht nur Leiterbahnen 3 entsprechend der vorgesehenen Schaltung hergestellt, sondern gleichzeitig Justiermarken 4. Die Justiermarken 4 sind z.B. kreis- oder schlitzförmige Ausätzungen in der Metallisierung 2. Die Tiefe der Justiermarken 4 entspricht der Dicke der Kupferfolie (etwa 0,3 bis 0,5mm), die als Metallisierung 2 verwendet wurde. Diese Tiefe reicht aus, um Montageteile am seitlichen Verrutschen zu hindern. Justiermarken 4 können innerhalb oder außerhalb von Leiterbahnen liegen.

Da die Leiterbahnen 3 und die Justiermarken 4 in einem Fertigungsschritt maskiert und geätzt werden, ist die Lage der Justiermarken 4 in bezug auf die Leiterbahnen 3 und auf eine Bezugskante oder -ecke des Substrats 1 sehr genau festgelegt. Dies erleichtert wesentlich eine automatische Bestückung des Substrats 1.

Der in Fig. 1 eingetragene gestrichelte Kreis deutet den Einbauort eines runden Bauelementes an.

Fig. 2 zeigt ein Substrat 1, das mit mehreren Montageteilen bestückt ist, nämlich einem Flachsteckeranschluß 5, einer Anschlußlasche 6, einem Thyristor 7, einem Gatebügel 8 und einem Kathodenkontaktbügel 9. Dabei sind mehrere Möglichkeiten zur Fixierung der Montageteile 5 bis 9 mit Hilfe von Justiermarken 4 vor und während eines Lötvorganges gezeigt. Der Flachsteckeranschluß 5, die Anschlußlasche 6 und der Kathodenkontaktbügel 9 weisen Fixierzapfen 10 auf, die in kreisrunde Justiermarken 4 ragen. Am Gatebügel 8 sind Krallen 11 vorgesehen, die in schlitzförmige Justiermarken 4 greifen. Der Thyristor 7 wird schließlich durch Hülsen 12 und Fixierstifte 13 fixiert.

Anschlußteile für Verbindungen nach außen, wie z.B. Anschlußlaschen 6 oder Flachsteckeranschlüsse 5 werden flach auf das Substrat 1 gelegt und erst nach erfolgter Lötung senkrecht nach oben gebogen. Um das spätere Biegen zu erleichtern, können Schlitze 14 oder Einkerbungen 15 an den Anschlußteilen 5, 6 vorgesehen werden. Anschlußteile 5, 6 und Substrat 1 werden zweckmäßig auf eine nicht dargestellte Platte gelegt, auf der die äußeren Enden der Anschlußteile 5,6 zusätzlich fixiert werden können, falls dies erforderlich ist, zur Sicherung gegen Verrutschen der Teile aufgrund von Trägheitskräften bei ruckartigen Beschleunigungen während des Ofendurchlaufs.

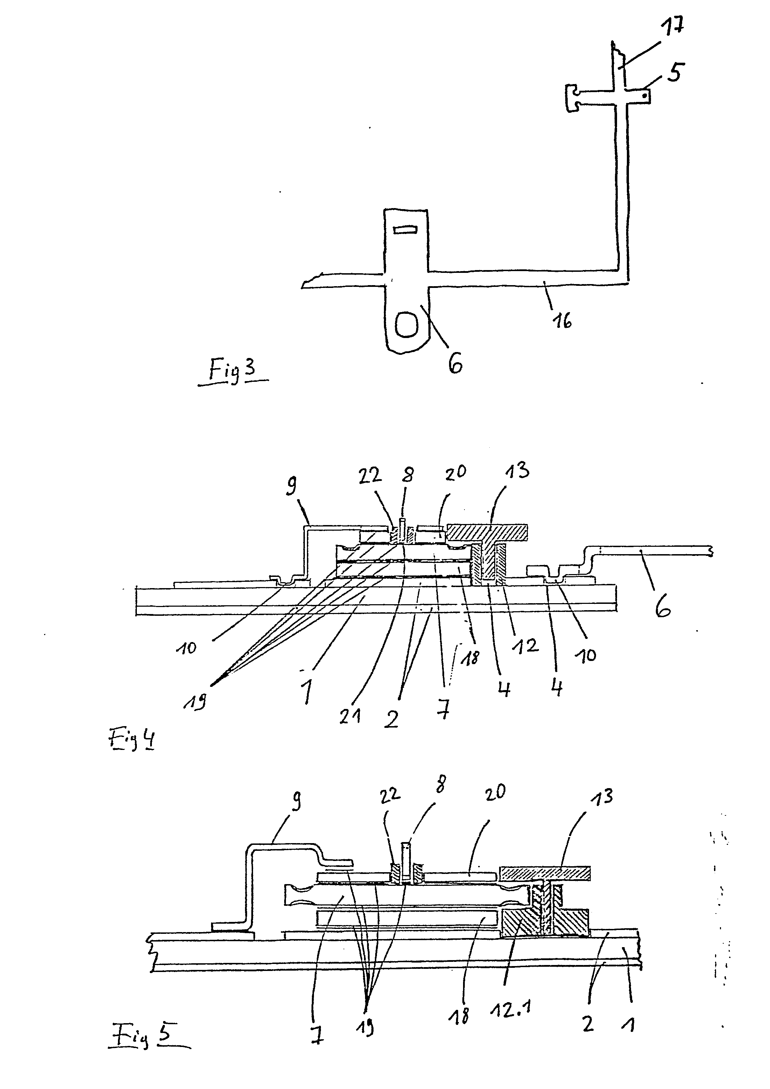

Nach einer in Fig. 3 dargestellten vorteilhaften Ausgestaltung können äußere Anschlußteile 5, 6 auch so hergestellt sein, daß sie über Zwischenstege 16 noch zusammenhängen, so daß sie ein einziges rahmenförmiges Metallteil 17 bilden. Erst nach dem Löten und eventuellen weiteren Montageschritten werden die Zwischenstege 16 in einem Stanzschritt entfernt. Vorteilhaft ist dabei, daß weniger Teile zu montieren sind und daß das rahmenförmige Metallteil 17 gut fixiert ist, da es an mehreren Stellen mit Fixierzapfen 10 in Justiermarken 4 in der Metallisierung 2 greift (Fig. 1 und 2).

Das Lotmaterial 23 wird als Folie vor dem Aufbringen der Anschlußteile 5, 6 oder des Metallteils 17 auf die Metallisierung 2 gelegt oder als Kugel bzw. dickere Scheibe in Öffnungen 24 jeweils am Fuß der Anschlußteile 5, 6 gelegt.

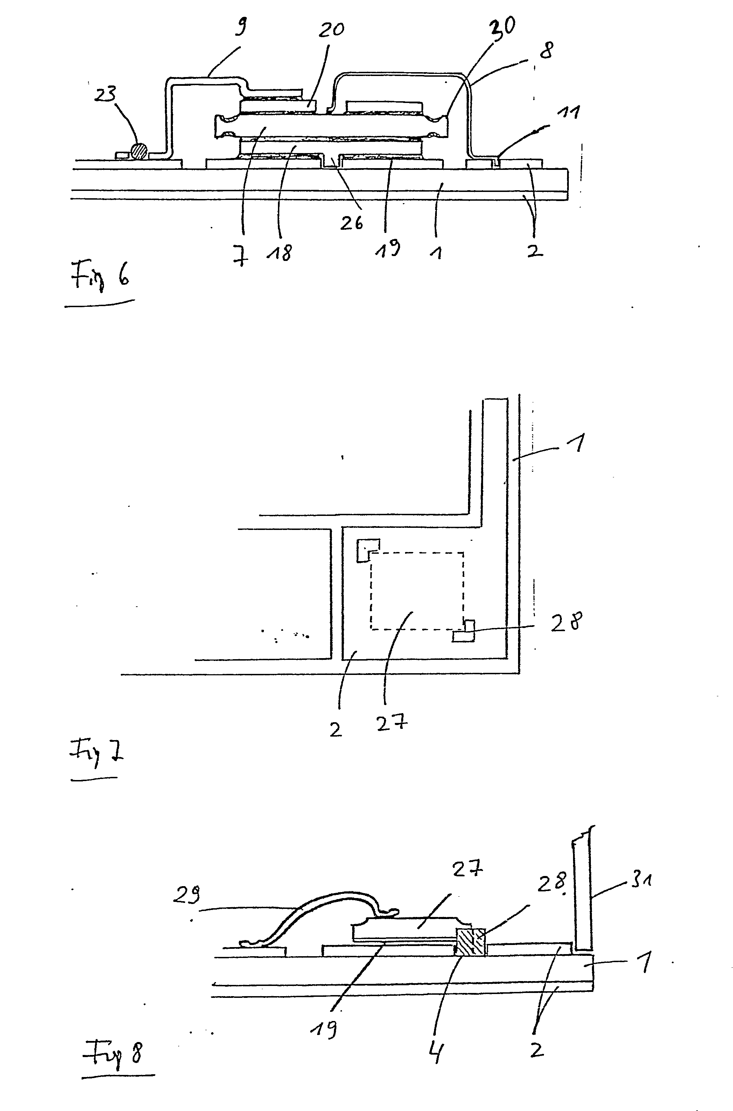

Bei dem in Fig. 2 und 4 dargestellten Thyristor 7 handelt es sich um einen rückwärts nicht sperrenden Thyristor (RNST oder ASCR). Den Fig. 2 und 4 ist zu entnehmen, daß ein solcher Thyristor 7 (bzw. ein sonstiges rundes Bauteil) mit Fixiereinrichtungen 12, 13 an drei Stellen am Umfang des Thyristors 7 fixiert werden kann. Dabei werden mit der Hülse 12 eine anodenseitige Molybdänronde 18 und der Thyristor 7 einschließlich Lotscheiben 19 fixiert. Lotscheiben 19 sind jeweils zwischen Metallisierung 2, anodenseitiger Molybdänronde 18, Thyristor 7, kathodenseitigem Molybdänring 20 und Kathodenkontaktbügel 9 sowie zwischen dem Gateanschluß 21 des Thyristors 7 und dem Gatebügel 8 angeordnet. In die Hülsen 12 werden Fixierstifte 13 gesteckt, womit der kathodenseitige Molybdänring 20 und die zugehörigen Lotscheiben 19 fixiert werden.

Die Hülsen 12 und Fixierstifte 13 werden nicht mit den übrigen Teilen 19 verlötet, sondern fallen später heraus, wenn das fertiggelötete Substrat gekippt wird. Die Hülsen 12 und Fixierstifte 13 können wieder verwendet werden. Die Hülsen 12 und Fixierstifte 13 können aus Keramik oder Metall, z.B. Stahl, hergestellt werden. Die Fixierstifte 13 haben z.B. einen Durchmesser von 4mm und eine Höhe von 2,5mm.

Zum Zentrieren des Lotplättchens 19 zwischen Gateanschluß 21 und Gatebügel 8 ist ein Keramikring 22 vorgesehen.

Die Montage der in Fig. 4 dargestellten Teile erfolgt in nachstehender Reihenfolge:

a) die Hülsen 12 werden in die Justiermarken 4 der Metallisierung 2 auf dem Keramiksubstrat 1 eingelegt,

b) unterste Lotscheibe 19 auf Metallisierung 2,

c) anodenseitige Molybdänronde 18,

d) zweite Lotscheibe 19,

e) Thyristor 7,

f) Fixierstifte 13,

g) ringförmige Lotscheibe 19 auf Thyristor 7,

h) Molybdänring 20,

i) ringförmige Lotscheiben 19 auf Molybdänring 20,

j) Kathodenkontaktbügel 9,

k) Keramikring 22 in Molybdänring 20 einsetzen,

l) Lotscheibe 19 an Gateanschluß 21,

m) Gatebügel 8,

n) Lot 23 in Öffnungen 24 am Fuß der Bügel 8, 9 einlegen (dargestellt in Fig. 2).

Fig. 5 zeigt eine Anordnung für einen üblichen Thyristor 7. Da die Hülse 12.1 in diesem Fall nach dem Löten nicht mehr entfernt werden kann, muß sie aus isolierendem Material (z.B. Keramik) bestehen.

Fig. 6 zeigt wie zweckmäßig ein vorgelöteter Sandwich 30 aus Thyristor 7, Molybdänronde 18 und Molybdänring 20 fixiert werden kann. Dabei weist die anodenseitige Molybdänronde 18 einen Zapfen 26 auf, der in eine Justiermarke 4 auf der Metallisierung 2 einrastet. Hülsen 12 und Fixierstifte 13 sind dabei überflüssig.

Solche Sandwich 30 werden z.B. mit einem PbSn5-Lot mit einer Schmelztemperatur von etwa 310oC vorgelötet, während die spätere Lötung auf dem Substrat 1 bzw. dessen Metallisierung 2 mit einem Lot mit wesentlich niedrigerer Schmelztemperatur erfolgt.

Die Figuren 7 und 8 zeigen wie ein rechteckiger Halbleiterchip, z.B. ein Transistor 27 direkt auf die Metallisierung 2 aufgelötet und mit Bonddrähten 29 aus Aluminium kontaktiert werden kann. Dabei genügen zur Fixierung zwei Winkelstücke 28 aus Keramik oder Metall, die in entsprechend geätzte Justiermarken 4 eingesetzt und nach der Lötung wieder entfernt werden können.

Für alle Beispiele gilt, daß ein fertig bestücktes und gelötetes Substrat 1 schließlich in ein Gehäuse 31 (Fig. 8) eingebaut und zur Isolation und zur Vermeidung elektrischer Überschläge mit einer geeigneten Kunststoffmasse vergossen wird. Bevorzugt wird als erste Vergießmasse ein Silikonkautschuk oder ein Silikon-Gel verwendet, die beim Vergießen auch enge Spalten füllen (z.B. zwischen Hülse 12.1 und dem Rand von Thyristor 7 bzw. Molybdänronde 18 in Fig. 5).

<u>A n s p r ü c h e</u>

1. Leistungshalbleitermodul in einem Gehäuse mit einem Keramiksubstrat als Gehäuseboden, wobei das Keramiksubstrat auf seiner dem Gehäuseinneren zugewandten Seite Metallisierungen aufweist, die als Leiterbahnen zum Verlöten mit Halbleiterbauelementen, internen Kontaktbügeln und externen Anschlußlaschen dienen, <u>dadurch gekennzeichnet,</u> daß das Keramiksubstrat (1) Justiermarken (4) in Form von Vertiefungen in der Metallisierung (2) aufweist, in die Ausformungen (10,11,12,12.1,26,28) zur Fixierung der Montageteile (5 bis 9, 18 bis 20, 27,30) beim Lötvorgang eingreifen.

2. Leistungshalbleitermodul nach Anspruch 1, dadurch gekennzeichnet, daß die Metallisierung (2) auf dem Substrat (1) mit einem Verfahren des direkten Verbindens von Kupfer mit Keramik aufgebracht ist.

3. Leistungshalbleitermodul nach Anspruch 1 oder 2, dadurch gekennzeichnet, daß Anschlußteile (5,6) an einer vorgesehenen Biegestelle Schlitze (14) oder Einkerbungen (15) aufweisen.

4. Leistungshalbleitermodul nach einem der Ansprüche 1 bis 3, dadurch gekennzeichnet, daß es sich bei den Ausformungen um Zapfen (10,26) oder Krallen (11) an Montageteilen (5,6,8,9,30) handelt.

5. Leistungshalbleitermodul nach einem der Ansprüche 1 bis 3, dadurch gekennzeichnet, daß es sich bei den Ausformungen um Hülsen (12,12.1) oder Winkelstücke (28) handelt, die zumindest während des Lötvorganges dicht neben Montageteilen (7,18,20,27) angeordnet sind.

6. Verfahren zur Herstellung des Leistungshalbleitermoduls nach einem der Ansprüche 1 bis 5, mit nachstehenden Herstellungsschritten, wobei von einem metallisierten Keramiksubstrat ausgegangen wird:

a) Herstellen von Leiterbahnen (3) und Justiermarken (4) durch Maskieren und Ätzen der Metallisierung (2) auf dem Keramiksubstrat (1),

b) Bestücken des Keramiksubstrats (1) mit Montageteilen (5 bis 9, 18, 20, 27, 30) und Lotmaterial (19,23), wobei die Montageteile (5 bis 9,18,20, 27,30) mit Hilfe von Ausformungen (10,11,12,12.1, 26,28) fixiert werden,

c) Löten des bestückten Substrats (1).

7. Verfahren nach Anspruch 6, dadurch gekennzeichnet, daß Ausformungen in Form von Zapfen (10,26) bzw. Krallen (11) an Montageteilen (5,6,8,9,30) vorgesehen sind.

8. Verfahren nach Anspruch 6, dadurch gekennzeichnet, daß Ausformungen in Form von Hülsen (12,12.1) bzw. Winkelstücken (28) verwendet werden, die an mehreren Stellen am Umfang von Montageteilen (7,18,20,27) angeordnet werden.

9. Verfahren nach Anspruch 8, dadurch gekennzeichnet, daß in die Hülsen (12,12.1) Fixierstifte (13) gesteckt werden zur Fixierung von Montageteilen (7,20).

10. Verfahren nach einem der Ansprüche 6 bis 9, dadurch gekennzeichnet, daß Anschlüsse (5,6) hochgebogen werden, das gelötete Substrat (1) in ein Gehäuse (31) eingebaut und vergossen wird.

0155473

11. Verfahren nach einem der Ansprüche 6 bis 10, dadurch gekennzeichnet, daß Anschlußteile (5,6) zunächst als über Zwischenstege (16) zusammenhängendes rahmenförmiges Metallteil (17) hergestellt, montiert und gelötet werden und erst nach dem Löten durch Entfernen der Zwischenstege (16) getrennt werden.

12. Verfahren nach einem der Ansprüche 6 bis 11, dadurch gekennzeichnet, daß das Löten in einem Durchlaufofen erfolgt.

13. Verfahren nach einem der Ansprüche 6 bis 12, dadurch gekennzeichnet, daß das Löten auf einer über die Schmelztemperatur des Lotes (19) aufheizbaren Platte erfolgt.

1/3

0155473

Fig 1

Fig 2

Fig 3

Fig 4

Fig 5

0155473

Fig 6

Fig 7

Fig 8

# EUROPÄISCHER RECHERCHENBERICHT

Europäisches Patentamt

## EINSCHLÄGIGE DOKUMENTE

| Kategorie | Kennzeichnung des Dokuments mit Angabe soweit erforderlich der maßgeblichen Teile | Betrifft Anspruch | KLASSIFIKATION DER ANMELDUNG (Int Cl.3) |
|---|---|---|---|
| A | EP-A-0 069 901 (BBC)<br><br>* Seite 4, Zeile 32 - Seite 5, Zeile 7; Seite 6, Zeilen 5-12 * & DE-A- 3 127 457 (Kat. D)<br><br>--- | 1-3,6, 10 | H 01 L 21/60<br>H 01 L 21/48<br>H 01 L 23/48 |
| A | DE-A-3 232 157 (SIEMENS)<br>* Seite 5, Zeile 32 - Seite 6, Zeile 11 *<br><br>--- | 1,4 | |
| A | EP-A-0 069 903 (BBC)<br>* Seite 2, Zeilen 10-30 *<br><br>--- | 1 | |
| A | DE-A-2 728 330 (SIEMENS)<br>* Anspruch 4 *<br><br>----- | 12 | |
| | | | **RECHERCHIERTE SACHGEBIETE (Int Cl.3)**<br><br>H 01 L 21/48<br>H 01 L 21/58<br>H 01 L 21/60<br>H 01 L 21/68<br>H 01 L 23/48<br>H 05 K 13/04 |

Der vorliegende Recherchenbericht wurde für alle Patentansprüche erstellt.

| Recherchenort | Abschlußdatum der Recherche | Prüfer |
|---|---|---|
| BERLIN | 22-05-1985 | GIBBS C.S. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82